# EUROPÄISCHE PATENTSCHRIFT

(11) **EP 2 695 488 B1**
(45) Veröffentlichungstag und Bekanntmachung des Hinweises auf die Patenterteilung: **24.01.2018**
(21) Anmeldenummer: 12720439.4
(22) Anmeldetag: 03.04.2012
(51) Int. Cl.: H05B 33/08, B60Q 11/00

(54) **SCHEINWERFER MIT LEUCHTDIODEN**
HEADLIGHT HAVING LIGHT-EMITTING DIODES
PROJECTEUR À DIODES ÉLECTROLUMINEUSES

(30) Priorität: 04.04.2011 DE 102011001780; 12.09.2011 DE 102011053491
(43) Veröffentlichungstag der Anmeldung: 12.02.2014
(73) Patentinhaber: JB-Lighting Lichtanlagentechnik GmbH, 89134 Blaustein (DE)
(72) Erfinder: HOFFMANN, Helge, 89269 Vöhringen (DE)
(74) Vertreter: Baur & Weber Patentanwälte PartG mbB
(86) Internationale Anmeldenummer: PCT/EP2012/056037
(87) Internationale Veröffentlichungsnummer: WO 2012/136640

(56) Entgegenhaltungen:
- WO-A1-2008/061301
- US-A1- 2009 085 489

## Beschreibung

Die Erfindung betrifft einen Scheinwerfer mit einer Mehrzahl von Leuchtdioden, welche elektrisch in mehreren Strängen mit jeweils mehreren seriell verschalteten Leuchtdioden angeordnet sind.

Bei Scheinwerfern, welche z. B. zur szenischen Beleuchtung in unterschiedlichen Situationen als sogenannte Washlights benutzt werden, werden zunehmend Leuchtdioden als Lichtquellen eingesetzt, wobei wegen der gegenüber Glühlampen geringen Lichtleistung einzelner Dioden eine Mehrzahl flächig verteilter Leuchtdioden eingesetzt sind. Dabei können auch jeweils wenige Dioden beispielsweise vier Dioden mit Emissionsfarben rot, grün, blau und weiß zu Kleingruppen eng zusammengefasst sein und mehrere solche Kleingruppen in der Fläche verteilt angeordnet sein. Typischerweise sind die flächig verteilten Dioden elektrisch seriell in Strängen verschaltet, wobei jedem Strang eine eigene, steuerbare elektrische Leistungsquelle zugeordnet ist und die über einen gesamten Strang abfallende Spannung zwischen 20 V und 60 V liegt. Es sind mehrere Stränge vorhanden, wobei in der Regel die Emissionsfarbe aller Leuchtdioden eines Stranges gleich ist. Bei den in solchen Scheinwerfern eingesetzten Hochleistungs-Leuchtdioden ist mit dem Ausfall einzelner Leuchtdioden zu rechnen, was dann zu Beleuchtungsfehlern, insbesondere Farbfehlern des Scheinwerferlichts führen kann. Das Erkennen eines Defekts ist häufig zufällig und die Identifizierung einer individuellen defekten Leuchtdiode insbesondere bei hochohmig defekter Leuchtdiode aufwändig.

Aus der US 2009/0085489 A1 ist eine Treiberschaltung für eine Lichtquelle bekannt. Diese Treiberschaltung beinhaltet ein Treibermodul, eine Vielzahl erster Schalter, eine Nachweiseinheit und eine Steuereinheit. Die Vielzahl der ersten Schalter sind jeweils mit einer entsprechenden Lichtquelle verbunden und diese Lichtquelle wird mit dem Treibermodul verbunden, um einen Arbeitspunkt für jede Lichtquelle zu detektieren und diesen an die Steuereinheit weiter zu leiten.

Aus der WO 2008/061301 A1 ist ein Fehlerdetektor bekannt, der eine Vielzahl von Signalen vergleicht, die einer Verteilung von elektrischer Leistung in entsprechenden Teilen einer Mehrfachanordnung von miteinander verbundenen lichterzeugenden Komponenten repräsentieren. Desweiteren wird ein Fehlersignal erzeugt, falls der Vergleich andeutet, dass wenigstens eine Änderung in der relativen Verteilung von elektrischer Leistung in Teilen der Mehrfachanordnung vorliegt, wobei diese Änderung ein Anzeichen für einen Fehler in wenigstens einer der lichterzeugenden Komponenten darstellt.

Der vorliegenden Erfindung liegt dabei die Aufgabe zugrunde, einen mit einer Mehrzahl von Leuchtdioden als Lichtquellen ausgestalteten Scheinwerfer dahingehend zu verbessern, dass eine defekte Leuchtdiode mit geringem Aufwand erkannt und identifiziert werden kann.

Erfindungsgemäße Lösungen sind in den unabhängigen Ansprüchen beschrieben. Die abhängigen Ansprüche enthalten vorteilhafte Ausgestaltungen und Weiterbildungen der Erfindung.

Durch das Abgreifen von Prüfsignalen an Positionen elektrischer Verbindungen seriell aufeinander folgender Leuchtdioden und das Auswerten der so gewonnenen Prüfsignale in einer Auswerteeinrichtung zur Ableitung einer Entscheidung über einen Diodendefekt kann insbesondere eine defekte Leuchtdiode erkannt und individuell identifiziert werden. Die Prüfsignale können insbesondere als Spannungswerte gewonnen werden, was vorteilhafterweise mit geringem Aufwand und praktisch verlustleistungsfrei erfolgen kann. Die Positionen, an welchen Prüfsignale abgegriffen werden, sind nachfolgend kurz als Abgriffe bezeichnet.

Die Auswertung der Prüfsignale in der Auswerteeinrichtung wird vorteilhafterweise digital durchgeführt, wofür die Auswerteeinrichtung oder die Prüfeinrichtung einen oder mehrere Analog-Digital-Wandler enthalten können. Ein Analog-Digital-Wandler kann zeitsequentiell für verschiedene Prüfsignale eingesetzt sein.

Die Auswertung der Prüfsignale in der Auswerteeinrichtung kann insbesondere den Vergleich eines an einem bestimmten Abgriff gewonnenen Prüfsignals mit einem oder mehrere zu diesem Abgriff gespeicherten Vergleichswerten oder Vergleichswertebereichen erfolgen. Alternativ oder zusätzlich können Prüfsignale von verschiedenen Abgriffen, insbesondere durch eine einzelne Leuchtdiode elektrisch getrennten Abgriffen desselben Stranges von Leuchtdioden bei der Auswertung kombiniert, insbesondere als Spannungsdifferenzen ausgewertet werden. Zusätzlich zu den Abgriffen zwischen seriell aufeinander folgenden Leuchtdioden eines Stranges können auch Abgriffe am Eingang und/oder Ausgang eines Stranges vorgesehen sein. Der Spannungswert am der Leistungsquelle zugeordneten Eingang eines Strangs kann auch direkt aus der dem Strang zugeordneten elektrischen Leistungsquelle oder aus einem Steuersignal zur Ansteuerung dieser Leistungsquelle abgeleitet werden. Der Strangausgang liegt typischerweise auf einem gemeinsamen Referenzpotential. Für die Auswertung kann eine Steuereinrichtung die den zu prüfenden Strang zugeordnete elektrische Leistungsquelle so ansteuern, dass die Leistungsquelle ein definiertes Testsignal, beispielsweise mit einer definierten Spannung über den gesamten Strang erzeugt.

Die Leitungen zwischen elektrisch seriell aufeinander folgenden Leuchtdioden sind zur Minimierung von elektrischen Leistungsverlusten vorteilhafterweise kurz, so dass die Abgriffe in der durch die flächig verteilte Anordnung der Leuchtdioden bestimmten Leuchtfläche des Scheinwerfers gleichfalls flächig verteilt vorliegen und die Prüfsignale über Prüfsignalleitungen zu der Auswerteeinrichtung geführt sind. Typischerweise ist die Gesamtheit aller Leuchtdioden mit einer großflächigen gemeinsame Platine elektrisch und mechanisch verbunden und die Prüfsignalleitungen können dann als Leiterbahnen der Platine ausgeführt sein.

Zur Verringerung der Gesamtlänge der Prüfsignalleitungen sind die Prüfsignale von mehreren Abgriffen verschiedener Stränge auf eine gemeinsame Sammelleitung zusammengeführt. Die Zusammenführung erfolgt vorteilhafterweise räumlich nahe bei den Abgriffen. Zur Vermeidung von gegenseitigen Beeinflussungen der dabei elektrisch verbundenen mehreren Stränge sind vorteilhafterweise in die Prüfsignalleitungen zwischen den Abgriffen und der Sammelleitung Rückwirkungssperren, vorzugsweise einfache Gleichrichterdioden eingefügt. Vorteilhafterweise sind mehrere soleher Sammelleitungen entsprechend den mehreren seriell aufeinander folgenden Abriffen eines Strangs vorgesehen.

Um die auf einer gemeinsamen Sammelleitung auftretenden Prüfsignale einer Gruppe von mehreren verschiedenen Strängen in der Auswerteeinrichtung einzeln auswerten zu können, werden vorteilhafterweise zur Auswertung des Prüfsignals eines Abgriffs eines bestimmten Strangs alle anderen Stränge, welche Prüfsignale auf dieselbe Sammelleitung liefern, für die Zeit der Gewinnung des einen Prüfsignals abgeschaltet. Insbesondere können alle Stränge der Leuchtdiodenanordnung in nur einer einzigen Gruppe zusammengefasst sein. Vorzugsweise werden dann, während nur ein Strang der Gruppe von der diesem Strang zugeordneten elektrischen Leistungsquelle mit elektrischer Leistung beaufschlagt ist die Prüfsignale aller Abgriffe dieses Strangs gleichzeitig oder zeitsequentiell gewonnen und somit der gesamte Strang auf Fehler überprüft, bevor die Prüfung dieses Strangs beendet und ein anderer Strang zur Überprüfung ausgewählt wird. Vorteilhafterweise kann eine Überprüfung aller Stränge in einer Beleuchtungspause oder speziellen Testphase durchgeführt werden.

Die automatische Auswertung von Prüfsignalen in der beschriebenen Art ist insbesondere auch von Vorteil bei Scheinwerfern, bei welchen die einzelnen Leuchtdioden durch einen Betrachter visuell nicht geometrisch voneinander trennbar sind.

In anderer Ausführung kann in Fällen, in welchen die geometrische Anordnung der Mehrzahl von Leuchtdioden für einen Betrachter erkennbar ist, eine visuelle Lokalisierung einer defekten Leuchtdiode erfolgen, indem Bypass-Strompfade vorgesehen sind, über welche im Falle einer hochohmig defekten Leuchtdiode ein Bypass-Strom über die defekte Leuchtdiode oder einen die defekte Leuchtdiode enthaltenden Teil des Stranges fließen kann. Hierdurch kann vorteilhafterweise eine Lichtemission der nicht defekten Leuchtdioden eines Stranges oder zumindest des nicht die defekte Leuchtdiode enthaltenden Teilstranges erreicht und daraus visuell die defekte Leuchtdiode identifiziert werden. Vorzugsweise verlaufen die Bypass-Strompfade von Abgriffen innerhalb eines Strangs zum Bezugspotential, so dass in dem vor einer direkten Leuchtdiode liegenden Teilstrang eine Lichtemission der Leuchtdioden durch den Bypass-Strom erreicht werden kann, wogegen die Leuchtdioden im Teilstrang ab der defekten Leuchtdiode keine Lichtemission zeigen.

In bevorzugter Ausführung fließen die Bypass-Ströme über die PrüfsignalLeitungen der Prüfsignale der bereits beschriebenen Auswertung, wofür vorteilhafterweise die Prüfsignalleitungen über einzelne oder gemeinsame Widerstände mit dem Bezugspotential verbunden oder verbindbar sind.

Die Erfindung ist nachfolgend anhand bevorzugter Ausführungsbeispiele unter Bezugnahme auf die Abbildungen noch eingehend veranschaulicht. Dabei zeigt:
- Fig. 1: ein elektrisches Schema einer Leuchtdiodenanordnung,
- Fig. 2: Bypass-Strompfade zu einem Leuchtdiodenstrang.

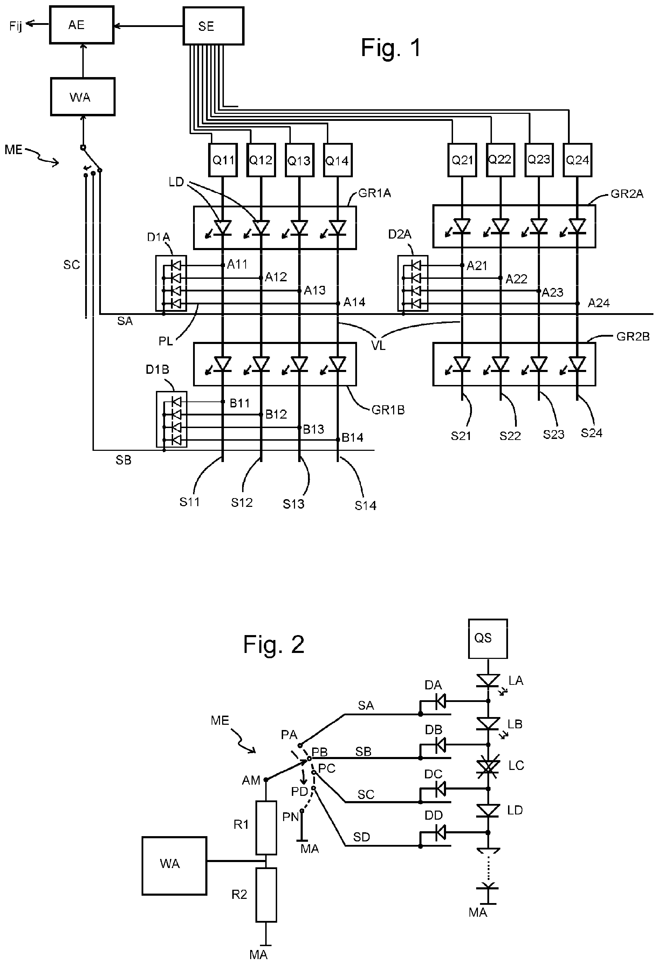

Fig. 1 zeigt in schematischer Anordnung für die Veranschaulichung der Erfindung wesentliche Komponenten des elektrischen Aufbaus eines Scheinwerfers mit einer Mehrzahl von Leuchtdioden LD. Die Leuchtdioden sind jeweils in Serienschaltung zu mehreren in mehreren Strängen angeordnet. Jedem Strang ist eine eigene, steuerbare elektrische Leistungsquelle zugeordnet. In Fig. 1 eingezeichnet sind auf elektrische Leistungsquellen Q11, Q12, Q13, Q14, Q21, Q22, Q23, Q24 folgende Anfangsabschnitte mit jeweils den beiden ersten Dioden der Stränge S11, S12, S13, S14, S21, S22, S23, S24. Die Leuchtdioden LD sind in an sich bekannter Weise in Leuchtdiodengruppen GR1A, GR2A, GR1B, GR2B zusammengefasst, wobei die Leuchtdioden einer Leuchtdiodengruppe insbesondere auch auf einem gemeinsamen Schaltungsträger vorliegen können und vorzugsweise in jeder der Gruppen die jeweils vier Leuchtdioden unterschiedliche Emissionsfarben, beispielsweise rot, grün, blau und weiß besitzen können. Innerhalb eines Strangs besitzen vorzugsweise alle Leuchtdioden dieselbe Emissionsfarbe. Die Schaltungsträger der Leuchtdiodengruppen GR1A, GR2A, GR1B, GR2B können vorteilhafterweise mit einer für alle Leuchtdioden gemeinsamen Schaltungsplatine, beispielsweise über Steckverbindungen verbunden sein. Verbindungsleitungen VL verbinden innerhalb eines Strangs aufeinanderfolgende Leuchtdioden elektrisch miteinander. An den Verbindungsleitungen zwischen innerhalb der jeweiligen Stränge aufeinander folgenden Leuchtdioden sind Abgriffe vorgesehen, an welchen Prüfsignale als Spannungswerte von den Verbindungsleitungen abgegriffen werden. Die Abgriffe sind für die Verbindungsleitungen zwischen den ersten und den zweiten Dioden mit dem Anfangsbuchstaben A und einer der jeweiligen Strangnummer entsprechenden Numerierung versehen. In der Verbindungsleitung zwischen der ersten und der zweiten Diode des Strangs S11 ist also der Abgriff mit A11 bezeichnet, beim Strang S12 ist der Abgriff mit A12 bezeichnet usw. Für die auf die zweiten Dioden folgenden und zu den jeweils dritten Dioden der Stränge führenden Verbindungsleitungen sind nur für die Stränge S11 bis S14 Abgriffe B11 bis B14 eingezeichnet und mit dem Anfangsbuchstaben B und einer Strangnummer versehen.

Die von den Abgriffen A11 bis A14 weg führenden Prüfsignalleitungen PL sind jeweils auf eine Gleichrichterdiode einer Diodenanordnung D1A geführt. Die den Abgriffen A11 bis A14 abgewandten Anschlüsse der Gleichrichterdioden sind mit einer Sammelleitung SA verbunden. In entsprechender Weise sind die von den Abgriffen A21 bis A24 weg führenden Prüfsignalleitungen über Gleichrichterdioden einer Diodenanordnung D2A auf die Sammelleitung SA geführt. In entsprechender Weise sind die von den Abgriffen B11 bis B14 weg führenden Prüfsignalleitungen über eine Diodenanordnung D1B auf eine Sammelleitung SB geführt. Die Gleichrichterdioden der Diodenanordnungen D1A, D2A, D1B usw. dienen als Rückwirkungssperren, um eine gegenseitige Beeinflussung der verschiedenen Stränge über die Prüfsignalleitungen und die gemeinsame Sammelleitung zu verhindern.

Eine Steuereinrichtung SE ist über Steuersignalleitungen mit den elektrischen Leistungsquellen Q11 bis Q14, Q21 bis Q24 usw. verbunden und ist in vorteilhafter Ausführung dafür eingerichtet, für die Durchführung eines Prüfzyklus jeweils nur eine der mehreren elektrischen Leistungsquellen zu aktivieren, so dass diese ihren zugeordneten Strang und die in diesem angeordneten Leuchtdioden mit elektrischer Leistung beaufschlagt, wogegen die anderen Stränge nicht mit elektrischer Leistung beaufschlagt sind und als abgeschaltet angesehen werden können. Die jeweils alleinig aktivierte elektrische Leistungsquelle beaufschlagt den zugeordneten Strang vorteilhafterweise mit einem nach Spannung oder Strom definierten Testsignal.

Im folgenden sei angenommen, dass für einen Prüfzyklus aktuell die Steuereinrichtung die elektrische Leistungsquelle Q11 des Stranges S11 zur Abgabe eines Testsignals in den Strang angesteuert habe und die übrigen Stränge abgeschaltet sind. An dem Abgriff A11 liegt damit eine erste Spannung an, welche über die zugeordnete Diode der Diodenanordnung D1A auf die Sammelleitung SA geführt ist. An dem Abgriff B11 desselben Strangs liegt eine andere Spannung vor, welche über die zugeordnete Diode der Diodengruppe D1B als weiteres Prüfsignal auf die Sammelleitung SB geführt ist. Im Verlauf des Stranges S11 weitere folgende Abgriffe führen jeweils zu weiteren Prüfsignalen, welche über entsprechende Diodenanordnungen auf weitere Sammelleitungen geführt sind, von welchen eine weitere Sammelleitung SC angedeutet ist.

Die Sammelleitungen SA, SB, SC sind einem Multiplexeingang ME eines Digital-Analog-Wandlers WA zugeführt, welcher zeitsequentiell die auf den einzelnen Sammelleitungen anstehenden Prüfsignale abfragt und als Digitalwerte einer Auswerteeinrichtung AE zuführt. Der Auswerteeinrichtung AE ist ferner von der Steuereinrichtung eine Information über die Strangnummer des aktuell aktivierten Strangs sowie eventuell der Spannung am Ausgang der zugeordneten elektrischen Leistungsquelle zugeführt, so dass die Auswerteeinrichtung AE einen von dem Digital-Analog-Wandler übernommenen Prüfsignalwert eindeutig einem Abgriff aus der Mehrzahl der Abgriffe zuordnen kann. Die Auswerteeinrichtung AE kann aus den zu einem Strang empfangenen Prüfsignalwerten durch Vergleich der Werte mit Sollwerten bzw. Sollwertbereichen, welche zu den einzelnen Abgriffen gespeichert sein können, und/oder durch Vergleich der Prüfsignalwerte untereinander entsprechend der Bildung von Differenzspannungen erkennen, ob eine der Dioden des aktuell geprüften Stranges defekt ist. Bei Erkennen eines Defektes gibt die Auswerteeinrichtung AE ein entsprechendes Fehlersignal Fij ab, welches die defekte Diode nach Strang und nach Position innerhalb des Strangs eindeutig identifiziert und eventuell auch bereits zwischen verschiedenen möglichen Fehlerarten unterscheidet.

Nach Erfassen aller Prüfsignale zu dem aktuellen Strang durch den Digital-Analog-Wandler kann dieser Strang abgeschaltet und die elektrische Leistungsquelle eines anderen Stranges, beispielsweise Q12 des Stranges S12, aktiviert werden, um entsprechende Prüfsignale zu dem Strang S12 zu gewinnen und in der Auswerteeinrichtung AE auf Diodenfehler hin auszuwerten.

Die Diodengruppen D1A, D2A, D1B usw. sind vorteilhafterweise in räumlicher Nähe der zugeordneten Leuchtdiodengruppen GR1A, GR2A, GR1B usw. angeordnet, um den Aufwand für die Führung von individuellen Prüfsignalleitungen zwischen den Abgriffen und den Sammelleitungen gering zu halten. Dies ist insbesondere von Vorteil bei in Gruppen GR1A, GR2A usw. zusammengefassten Leuchtdioden. Die Sammelleitungen verringern den Aufwand für die Leitungsführung auf der für alle Leuchtdioden gemeinsamen Platine erheblich und ermöglichen auch mit geringem Aufwand eines Eingangs-Multiplexers die Verwendung eines einzigen Digital-Analog-Wandlers WA für die Gesamtheit aller Leuchtdioden bzw. Stränge. Für einen Scheinwerfer können beispielsweise 24 Stränge mit jeweils 12 seriell verschalteten Leuchtdioden vorgesehen sein, so dass entlang jedes Stranges 11 Abgriffe vorliegen und die Prüfsignale von 11 x 24 = 264 Abgriffen über nur 11 Sammelleitungen der Auswerteeinrichtung AE bzw. dem dieser vorgeschalteten Digital-Analog-Wandler zuleitbar sind. Dabei sind jeder Sammelleitung Prüfsignale von Abgriffen von 24 verschiedenen Strängen zugeführt. In anderer Ausführung können auch die beispielhaft genannten 24 Stränge in mehrere, beispielsweise zwei Stranggruppen mit jeweils 12 Strängen unterteilt sein und jede Stranggruppe ihre einzelnen Sammelleitungen besitzen, so dass sich insgesamt 22 Sammelleitungen ergeben. Prüfzyklen können dann für die beiden Stranggruppen gleichzeitig parallel durchgeführt werden, so dass sich die Dauer eines Prüfzyklus entsprechend verringert.

Die mehreren Stränge enthalten nicht notwendigerweise alle dieselbe Anzahl von Leuchtdioden in Serie. Die Anzahl der Sammelleitungen bestimmt sich nach den Strängen mit der größten Anzahl von in Serie geschalteten Leuchtdioden.

Fig. 2 zeigt einen Ausschnitt aus einer Verschaltung eines Leuchtdiodenstranges, von welchem aufeinanderfolgend ab einer diesem Strang zugeordneten Stromquelle QW Leuchtdioden LA, LB, LC und LD eingezeichnet sind. Dabei sei angenommen und mit Durchkreuzen angedeutet, dass die Leuchtdiode LC hochohmig defekt sei, so dass der Strang blockiert ist und an sich keine der Leuchtdioden Licht emittiert. Hierdurch ist für einen Betrachter auch nicht erkennbar, welche der mehreren Leuchtdioden des Stranges defekt ist.

Für eine visuelle Erkennung einer defekten Leuchtdiode innerhalb eines Strangs kann vorteilhafterweise auf die bereits zu Fig. 1 im Detail geschilderte Prüfeinrichtung mit den auf Sammelleitungen SA, SB, SC, SD geführten, zwischen aufeinander folgenden Leuchtdioden abgegriffenen und über Dioden DA, DB, DC, DD als Rückwirkungssperren geführten Prüfsignalen zurückgegriffen werden.

Die Sammelleitungen SA, SB, SC, SD seien wie im Beispiel nach Fig. 1 vorgesehen über einen Multiplexer ME als Umschalter einzeln selektiv mit einem Digital-Analog-Wandler WA verbindbar, indem die mehreren Eingangsanschlüsse PA, PB, PC, PD des Multiplexers ME einzeln mit dem gemeinsamen Ausgang AM des Multiplexers verbindbar sind, welcher wiederum mit dem Eingangsanschluss des Digital-Analog-Wandlers verbunden ist. Der gemeinsame Ausgangsanschluss AM des Multiplexers ME bzw. der Eingang des Digital-Analog-Wandlers WA ist über eine Widerstandsordnung mit dem Bezugspotential MA verbunden, welches auch das der Stromquelle QS abgewandte Bezugspotential des Leuchtdioden-Stranges bildet. Die Widerstandsordnung ist im skizzierten Beispielsfall vorteilhafterweise durch einen Spannungsteiler R1, R2 gebildet, welcher die maximale Spannung am Ausgangsanschluss AM des Multiplexers ME auf eine niedrigere maximale Spannung am Eingang des Digital-Analog-Wandlers reduziert.

Bei Verbindung eines der mehreren Eingangsanschlüsse PA, PB, PC, PD des Multiplexers ME entsteht für den jeweils zugeordneten Abgriff des Leuchtdiodenstrangs ein Bypass-Strompfad zum Bezugspotential MA über die Widerstandsanordnung R1, R2, über welchen auch bei dem infolge der defekten Leuchtdiode LC unterbrochenen Strang ein Bypass-Strom fließen kann, wenn der Abgriff vor der defekten Leuchtdiode LC liegt.

In der in Fig. 2 dargestellten Schaltstellung des Multiplexers ME ist der Abgriff zwischen der intakten Leuchtdiode LB und der defekten Leuchtdiode LC des Stranges über den Eingangsanschluss PB des Multiplexers ME mit dem Ausgang AM des Multiplexers verbunden, so dass ein Bypass-Strompfad von dem Abgriff zwischen den Leuchtdioden LB und LC über die Rückwirkungssperre DB, den Multiplexer und die Widerstandsanordnung R1, R2 zum Bezugspotential MA gegeben ist. Über diesen Bypass-Strompfad kann in dieser Schalterstellung des Multiplexers ME ein Bypass-Strom führen, welcher zu einer Lichtemission durch die Dioden LA und LB führt. Der Bypass-Strom führt nicht über die in Strangrichtung von der Stromquelle QS zum Bezugspotential MA nach der defekten Leuchtdiode LC angeordneten Leuchtdioden LD und folgende, so dass neben der defekten Leuchtdiode LC auch die nachfolgenden Leuchtdioden LD kein Licht emittieren.

In entsprechender Weise wäre in der vorausgegangenen Schalterstellung des Multiplexers mit Verbindung des Eingangs PA mit dem Ausgang AM ein Bypass-Strom durch die Leuchtdiode LA, hingegen nicht durch alle anderen Leuchtdioden des Stranges gegeben.

Bei Weiterschalten des Multiplexers kann kein Bypass-Strom durch die jeweiligen Prüfsignalleitungen SC, SD fließen, weil die Abgriffe nach der Unterbrechung des Stranges durch die defekte Leuchtdiode LC liegen.

Für einen Betrachter ergibt sich damit beim Durchschalten des Multiplexers ME bei Aufschalten von Abgriffen vor der defekten Leuchtdiode eine Lichtemission der im Strang vor der defekten Leuchtdiode LC liegenden Leuchtdioden LA, LB, wogegen die Leuchtdiode LC und die im Strang nachfolgenden Leuchtdioden in keiner Schalterstellung des Multiplexers ME eine Lichtemission zeigen. Für den Betrachter unterteilt sich damit der gesamte Leuchtdiodenstrang zwischen der Stromquelle QS und dem Bezugspotential MA in einen ersten Teilstrang mit lichtemittierenden Leuchtdioden LA und LB und einen zweiten Teilstrang mit Dioden LC, LD ohne Lichtemission. Daraus ist unmittelbar ableitbar, dass die im zweiten Teilstrang an erster Position stehende Leuchtdiode LC defekt ist und ausgewechselt werden muss.

Die Stromstärke des Bypass-Stroms ist maßgeblich durch den Widerstandswert der Widerstandsordnung R1, R2 bestimmt und beträgt vorteilhafterweise maximal 5 %, insbesondere weniger als 2,5 %, vorzugsweise weniger als 1 % des regulären Stroms durch den Strang zwischen der Stromquelle QS und dem Bezugspotential MA, wobei als ein solcher regulärer Strom der Strom einer Situation mit über den gesamten Strang intakten Leuchtdioden gesehen sei, und wobei für den Stromstärkenvergleich zwischen Bypass-Strom und regulärem Strom jeweils dieselbe Spannung zwischen Ausgang der Stromquelle QS und Bezugspotential MA angenommen sei. Der Widerstandswert der Widerstandsanordnung liegt vorteilhafterweise zwischen 50 kOhm und 500 kOhm.

Für den Multiplexer ME kann vorteilhafterweise eine Ruhestellung vorgesehen sein, in welcher ein mit Bezugspotential MA verbundener Eingang PN mit dem gemeinsamen Ausgang AM des Multiplexers verbunden ist, so dass in dieser Ruhestellung grundsätzlich kein Bypass-Strom fließen kann. die visuelle Unterscheidung der beiden Teilstränge ergibt sich dann in einer Prüfphase mit über die Eingangsanschlüsse P1 bis PN durchgetakteten Multiplexer ME. Aufgrund des niedrigen Bypass-Stroms kann eine solche Prüfphase auch einem regulären Scheinwerferbetrieb überlagert durchführbar sein.
Anstelle der Widerstandsanordnung am gemeinsamen Ausgangsanschluss AM des Multiplexers ME können auch eine Mehrzahl von Widerstandsanordnungen vorgesehen sein, welche die einzelnen Prüfsignalleitungen SA, SB, SC, SD jeweils für sich mit dem Bezugspotential verbinden, wobei dann, wenn keine zusätzlichen Schaltmittel vorgesehen sind, jeweils dauerhaft Bypass-Ströme über die Prüfsignalleitungen und die zugeordneten Widerstandsanordnungen fließen. Die einzelnen Widerstandsanordnungen können dabei unterschiedliche Widerstandswerte und, bei Ausführung als Spannungsteiler, unterschiedliche Teilerfaktoren aufweisen.
Anstelle eines Digital-Analog-Wandlers, welcher über einen Multiplexer ME mit einer Mehrzahl von getrennten Prüfsignalleitungen verbunden ist, können auch mehrere Digital-Analog-Wandler vorgesehen sein.
Die vorstehend und die in den Ansprüchen angegebenen sowie die den Abbildungen entnehmbaren Merkmale sind sowohl einzeln als auch in verschiedener Kombination vorteilhaft realisierbar.

## Patentansprüche

1. Scheinwerfer mit einer Diodenanordnung, welche eine Mehrzahl von Leuchtdioden als Lichtquellen enthält, wobei die Leuchtdioden elektrisch in mehreren Strängen (S11, S12, ...) mit jeweils mehreren seriell verschalteten Leuchtdioden (LD) angeordnet sind, und mit einer Überwachungseinrichtung zur elektrischen Erkennung defekter Dioden (PL, D1A, SA), wobei eine solche Überwachungseinrichtung eine Prüfsignalanordnung zur Ableitung von Prüfsignalen an Abgriffen (A11, A12, ...) zwischen seriell aufeinander folgenden Leuchtdioden und eine Auswerteeinrichtung (AE), welche zur Erkennung eines Defekts einzelner Leuchtdioden aus den Prüfsignalen ausgebildet ist, enthält,
**dadurch gekennzeichnet, dass** Prüfsignale von Abgriffen (A11, A12, ...) verschiedener Stränge (S11, S12, ...) auf eine gemeinsame Sammelleitung zusammengeführt sind.

2. Scheinwerfer nach Anspruch 1, **dadurch gekennzeichnet, dass** eine Steuereinrichtung (SE) vorhanden ist, welche zur Beaufschlagung einzelner Stränge mit elektrischer Leistung eingerichtet ist.

3. Scheinwerfer nach Anspruch 2, **dadurch gekennzeichnet, dass** die Steuereinrichtung (SE) zur Durchführung eines Testlaufs eingerichtet ist, in welchem zeitlich sequentiell einzelne Stränge (S11, S12, ...) mit elektrischer Leistung beaufschlagbar sind.

4. Scheinwerfer nach einem der Ansprüche 1 bis 3, **dadurch gekennzeichnet, dass** die Auswerteeinrichtung (AE) zum Vergleich von Prüfsignalen mit dazu gespeicherten Wertebereichen eingerichtet ist.

5. Scheinwerfer nach einem der Ansprüche 1 bis 4, **dadurch gekennzeichnet, dass** die Auswerteeinrichtung zum Vergleich mehrerer Meßwerte von verschiedenen Abgriffen (A11, B11) eines Strangs (S11) ausgebildet ist.

6. Scheinwerfer nach Anspruch 1, **dadurch gekennzeichnet, dass** zwischen die Abgriffe (A11, A12, ...) und die Sammelleitung (SA) Rückwirkungssperren, insbesondere Dioden (D1A) eingefügt sind.

7. Scheinwerfer nach Anspruch 6, **dadurch gekennzeichnet, dass** mehrere, unterschiedlichen Abgriffe (A11, B11) eines Strangs (S11) zugeordnete Sammelleitungen (SA, SB) vorgesehen sind.

8. Scheinwerfer nach einem der Ansprüche 1 bis 7, **dadurch gekennzeichnet, dass** für die Auswertung eines Prüfgsignals auf der Sammelleitung (SA) durch die Steuereinrichtung lediglich an einem Strang der Gruppe eine Spannung angelegt ist.

9. Scheinwerfer nach einem der Ansprüche 1 bis 8, **dadurch gekennzeichnet, dass** die Auswerteeinrichtung wenigstens einen Analog-Digital-Wandler (WA) enthält, welchem zeitsequentiell Prüfsignale von unterschiedlichen Abgriffen zuführbar sind.

## Claims

1. Headlamp having a diode arrangement, which contains a plurality of light-emitting diodes as light sources, wherein the light-emitting diodes are electrically arranged in a plurality of strands (S11, S12, ...) each having a plurality of light-emitting diodes (LD) interconnected in series, and having a monitoring device for electrical identification of faulty diodes (PL, D1A, SA), wherein such a monitoring device contains a test signal arrangement for deriving test signals at taps (A11, A12, ...) between serially successive light-emitting diodes and an evaluation device (AE), which is embodied to identify from the test signals a fault in individual light-emitting diodes,
**characterized in that**
test signals from taps (A11, A12, ...) of different strands (S11, S12, ...) are combined on a common collection line.

2. Headlamp according to Claim 1, **characterized in that** a control device (SE), which is configured to supply individual strands with electrical power, is provided.

3. Headlamp according to Claim 2, **characterized in that** the control device (SE) is configured to carry out a test run in which individual strands (S11, S12, ...) can be supplied with electrical power in a temporally sequential manner.

4. Headlamp according to one of Claims 1 to 3,
**characterized in that** the evaluation device (AE) is configured to compare test signals with value ranges stored therefor.

5. Headlamp according to one of Claims 1 to 4,
**characterized in that** the evaluation device is embodied to compare a plurality of measurement values from different taps (A11, B11) of one strand (S11).

6. Headlamp according to Claim 1, **characterized in that** feedback barriers, in particular diodes (D1A), are inserted between the taps (A11, A12, ...) and the collection line (SA).

7. Headlamp according to Claim 6, **characterized in that** a plurality of collection lines (SA, SB) assigned to different taps (A11, B11) of one strand (S11) are provided.

8. Headlamp according to one of Claims 1 to 7,
**characterized in that** the control device applies a voltage to just one strand of the group for the evaluation of a test signal on the collection line (SA) .

9. Headlamp according to one of Claims 1 to 8,
**characterized in that** the evaluation device contains at least one analogue-to-digital converter (WA), to which test signals from different taps can be fed in a temporally sequential manner.

## Revendications

1. Projecteur comportant un réseau de diodes, qui comprend une pluralité de diodes électroluminescentes en tant que sources lumineuses, dans lequel les diodes électroluminescentes sont disposées électriquement dans une pluralité de chaînes (S11, S12, ...) ayant chacune une pluralité de diodes électroluminescentes (LD) connectées en série, et comportant un dispositif de surveillance pour la détection électrique de diodes défectueuses (PL, D1A, SA), dans lequel ledit dispositif de surveillance comprend un système de signal de test permettant de prélever des signaux de test sur des prises (A11, A12, ...) entre des diodes électroluminescentes connectées séquentiellement en série et un dispositif d'évaluation (AE) qui est conçu pour détecter un défaut de diodes électroluminescentes individuelles à partir des signaux de test,
**caractérisé en ce que** des signaux de test provenant de prises (A11, A12, ...) de différentes chaînes (S11, S12, ...) sont réunis sur une ligne collectrice commune.

2. Projecteur selon la revendication 1,
**caractérisé en ce qu'**il est prévu un dispositif de commande (SE) conçu pour alimenter en énergie électrique des chaînes individuelles.

3. Projecteur selon la revendication 2,
**caractérisé en ce que** le dispositif de commande (SE) est conçu pour effectuer un test lors duquel des chaînes individuelles (S11, S12, ...) peuvent être alimentées en énergie électrique séquentiellement dans le temps.

4. Projecteur selon l'une quelconque des revendications 1 à 3, **caractérisé en ce que** le dispositif d'évaluation (AE) est conçu pour comparer des signaux de test à des plages de valeurs stockées à cet effet.

5. Projecteur selon l'une quelconque des revendications 1 à 4, **caractérisé en ce que** le dispositif d'évaluation est conçu pour comparer plusieurs valeurs de mesure de différentes prises (A11, B11) d'une chaîne (S11).

6. Projecteur selon la revendication 1,
**caractérisé en ce que** des dispositifs de blocage anti-retour, en particulier des diodes (D1A), sont insérés entre les prises (A11, A12, ...) et la ligne collectrice (SA).

7. Projecteur selon la revendication 6,
**caractérisé en ce qu'**il est prévu plusieurs lignes collectrices (SA, SB) associées à différentes prises (A11, S11) d'une chaîne (S11).

8. Projecteur selon l'une quelconque des revendications 1 à 7, **caractérisé en ce qu'**une tension est appliquée à la ligne collectrice (SA) par le dispositif de commande uniquement à une chaîne du groupe pour l'évaluation d'un signal de test.

9. Projecteur selon l'une quelconque des revendications 1 à 8, **caractérisé en ce que** le dispositif d'évaluation comporte au moins un convertisseur analogique-numérique (WA) auquel des signaux de test peuvent être délivrés séquentiellement dans le temps en provenance de différentes prises.
